# EUROPÄISCHE PATENTSCHRIFT

(11) **EP 2 674 769 B1**
(45) Veröffentlichungstag und Bekanntmachung des Hinweises auf die Patenterteilung: **20.08.2014**
(21) Anmeldenummer: 12171824.1
(22) Anmeldetag: 13.06.2012
(51) Int. Cl.: G01R 31/28, G01R 1/04, H05K 13/02, H01L 21/67

(54) **Vorrichtung und Verfahren zum Entnehmen von geprüften Halbleiterbauelementen**
Device and method for removing tested semiconductor elements
Dispositif et procédé de retrait de composants semi-conducteurs contrôlés

(43) Veröffentlichungstag der Anmeldung: 18.12.2013
(73) Patentinhaber: Multitest elektronische Systeme GmbH, 83026 Rosenheim (DE)
(72) Erfinder: Hofmann, Thomas, 83071 Stephanskirchen (DE); Akkermann, Klaas, 83026 Rosenheim (DE); Kurz, Stefan, 83026 Rosenheim (DE); Nagy, Andreas, 81549 München (DE); Pötzinger, Johann, 83730 Fischbachau (DE); Lorenz, Bernhard, 85417 Marzling (DE)
(74) Vertreter: Dilg, Haeusler, Schindelmann Patentanwaltsgesellschaft mbH

(56) Entgegenhaltungen:
- EP-A2- 2 302 399
- WO-A1-2009/100910
- US-A- 5 307 011
- US-A1- 2002 054 813
- US-A1- 2011 265 316

## Beschreibung

Die Erfindung betrifft eine Vorrichtung und ein Verfahren zum Entnehmen von geprüften Halbleiterbauelementen nach dem Oberbegriff von Ansprüchen 1 und 2 bzw. dem Oberbegriff von Ansprüchen 9 und 10.

Elektronische Halbleiterbauelemente, wie beispielsweise Integrierte Schaltkreise, Prozessoren, Sensorelemente etc., werden nach ihrer Herstellung üblicherweise bestimmten Tests unterzogen, um ihre Funktionen zu überprüfen. Hierzu gehören sowohl die elektronischen, als auch beispielsweise sensorische Funktionen. Vor kurzem sind sogenannte Klemmträger bekannt geworden, auf denen eine Vielzahl der elektronischen Bauteilelemente befestigt werden können. Diese Träger werden dann an einen sogenannten Handler übergeben und in diesem exakt für die Prüfung positioniert.

Ein solcher Klemmträger wird beispielsweise in der WO 2009/100910 A1 beschrieben.

Der Handler weist einen feststehenden Testkopf auf, mit dem ein ebenfalls feststehender Prüfsockel verbunden ist. Für elektronische Tests ist dieser Prüfsockel so ausgeführt, dass normalerweise alle Halbleiterbauelemente auf dem Klemmträger gleichzeitig kontaktiert und geprüft werden können.

Bei der Prüfung wird zu jedem Klemmträger eine Datei angelegt, in der entweder das Testergebnis für jedes Halbleiterbauelement des Klemmträgers vermerkt wird, oder die für jedes Halbleiterbauelement nur die Information enthält, in welche Kategorie das Halbleiterbauelement einzuordnen ist. Diese Datei wird entweder auf einem Zentralrechner, dem Klemmträger selbst oder in einer Kassette gespeichert, die mehrere solcher Klemmträger aufnimmt. Der Erfindung liegt die Aufgabe zugrunde, eine Vorrichtung beziehungsweise ein Verfahren zu schaffen, um die Halbleiterbauelement dem Klemmträger zu entnehmen und die für gut befundenen Halbleiterbauelemente geordnet einer Verpackung zuzuführen. Die verpackten Halbleiterbauelemente sollen in üblichen Bestückungsautomaten verarbeitet werden können.

Gelöst wird die Aufgabe gemäß der Erfindung durch eine Vorrichtung mit den Merkmalen von Anspruch 1 bzw. 2 bzw. durch ein Verfahren mit den Merkmalen von Anspruch 9 bzw. 10.

Erfindungsgemäß weist ein erstes Ausführungsbeispiel folgende Merkmale auf: eine über dem Klemmträger angeordnete Betätigungseinrichtung, die die Klemmelemente in eine das Entleeren des Klemmträgers ermöglichende Öffnungsstellung und nach dem Entleeren in eine Ruhestellung bewegt, ein während des Entleerens unter dem Klemmträger positionierter Zwischenträger, auf den der Klemmträger entleert wird, ein Datenspeicher in dem Daten zu jedem Halbleiterbauelement abgelegt sind und eine Entnahmeeinrichtung die die Halbleiterbauelemente aus dem Zwischenträger entnimmt und entsprechend der in dem Datenspeicher abgelegten Daten in wenigstens zwei unterschiedliche Kategorien sortiert.

Bei diesem Ausführungsbeispiel kann entweder der Klemmträger bereits so zugeführt werden, dass sich die Halbleiterbauelemente an seiner Unterseite befinden. Wird der Klemmträger in normaler Ausrichtung, mit den Halbleiterbauelementen auf seiner Oberseite, zugeführt, muss eine zusätzliche Einrichtung vorgesehen werden, die den Klemmträger vor seiner Entleerung über eine horizontale Achse dreht.

In beiden Fällen werden sich die Halbleiterbauelemente nach dem Öffnen der Klemmelemente allein durch die Schwerkraft von dem Klemmträger lösen und in den Zwischenträger fallen. Nun befinden sich die Halbleiterbauelemente in einer Orientierung, entgegengesetzt zu ihrer Orientierung auf dem Klemmträger. In dieser Orientierung können sie der Verpackung zugeführt werden.

Daten zu jedem Halbleiterbauelement können auf dem Klemmträger abgespeichert sein. Die Daten können beim Test der Halbleiterbauelemente erzeugt und dort direkt in einen Speicher auf dem Klemmträger eingeschrieben werden. Üblicherweise werden die Prüfdaten aber auf einem Zentralrechner abgelegt und einem Klemmträger über einen Identifikationscode zugeordnet. Sobald der Klemmträger über diesen Code in der Entnahmevorrichtung erkannt wird, werden die Daten zu den Halbleiterbauelementen dieses Klemmträgers von dem Zentralrechner abgerufen.

Die zu jedem Halbleiterbauelement abgelegten Daten können unterschiedliche Informationen beinhalten. So kann es sich bei den Daten um die reinen Testergebnisse handeln, die in der Entnahmevorrichtung erst ausgewertet werden, um dann eine Entscheidung über die weitere Behandlung des Halbleiterbauelements zu treffen. Diese Entscheidung kann aber auch bereits in dem Zentralrechner oder in der Testvorrichtung vorgenommen werden, so dass sich die von der Entnahmevorrichtung eingelesenen Daten nur noch auf die Kategorie beziehen, der das jeweilige Halbleiterbauelements zugeordnet wurde.

Die Kategorien, in die die Halbleiterbauelemente in der Entnahmevorrichtung sortiert werden, sind zumindest eine Kategorie, die besagt, dass alle Funktionen des Halbleiterbauelements erfüllt sind und eine weitere Kategorie, die als Abfall entsorgt werden muss.

Ein zweites Ausführungsbeispiel der Erfindung weist folgende Merkmale auf: eine Betätigungseinrichtung, die die Klemmelemente in eine das Entnehmen des Klemmträgers ermöglichende Öffnungsstellung und nach dem Entnehmen in eine Ruhestellung bewegt, einen Datenspeicher in dem Daten zu jedem Halbleiterbauelement abgelegt sind, eine Entnahmeeinrichtung, die die Halbleiterbauelemente aus dem Klemmträger entnimmt und eine Dreheinrichtung zum Drehen von aus dem Klemmträger entnommenen Halbleiterbauelementen über eine zur Entnahmerichtung senkrechte Achse.

Unter Dreheinrichtung wird hier eine Einrichtung verstanden, die die Halbleiterbauelemente so übernimmt, dass sie in einer gedrehten Orientierung, also mit ihrer bisherigen Unterseite nach oben, abgelegt werden können.

Bei diesem Ausführungsbeispiel werden die Klemmträger der Entnahmevorrichtung so zugeführt, dass sich die Halbleiterbauelemente auf der Oberseite des Klemmträgers befinden. Da die Halbleiterbauelemente also hier in der Orientierung von dem Klemmträger entnommen werden, in der sie auch in der Testvorrichtung an den Prüfsockel gedrückt werden, müssen sie, bevor sie einer Verpackung zugeführt werden, gedreht werden, so dass die dem Klemmträger zugewandte Seite nach oben zu liegen kommt. Die Dreheinrichtung kann neben, unter oder über der Entnahmeeinrichtung angeordnet sein.

Sowohl die Entnahmeeinrichtung als auch die Dreheinrichtung weisen wenigstens eine Saugnadel auf, mit der ein Halbleiterbauelement durch die Erzeugung eines Vakuums gehalten wird. Das Halbleiterbauelement wird so von der Saugnadel der Entnahmeeinrichtung an die Saugnadel der Dreheinrichtung übergeben, dass sich beide Saugnadeln gegenüberstehen und auf gegenüberliegende Seiten des Halbleiterbauelements aufsetzen.

Bei einer oberhalb der Entnahmeeinrichtung angeordneten Drehvorrichtung wird zur Übergabe des Halbleiterbauelements beziehungsweise der Halbleiterbauelemente die Entnahmeeinrichtung um eine horizontale Achse, die senkrecht zur Entnahmerichtung ausgerichtet ist, um 180° gedreht, so dass die Saugnadel bzw. die Saugnadeln senkrecht nach oben stehen. Die Saugnadel bzw. die Saugnadeln der Dreheinrichtung setzen nun von oben direkt gegenüber den Saugnadeln der Entnahmeeinrichtung auf das oder auf die Halbleiterbauelemente auf.

Nach der Übernahme durch die Dreheinrichtung kann diese in X-Y-Richtung verfahren werden, um die Halbleiterbauelemente an die Verpackung zu überführen. Ist die Dreheinrichtung neben der Entnahmeeinrichtung angeordnet, so verschwenkt die Entnahmeeinrichtung nur um 90° um die Halbleiterbauelemente zu übergeben. Nach der Übergabe verschwenkt auch die Dreheinrichtung um 90°, so dass die Saugnadeln der Dreheinrichtung wieder nach unten ausgerichtet sind. Auch hier können die Halbleiterbauelemente nun durch Verfahren in X-Y-Richtung an ein Verpackung übergeben werden. Ist die Dreheinrichtung aber unterhalb der Entnahmeeinrichtung angeordnet, so muss die Entnahmeeinrichtung erst verfahren werden um über der Dreheinrichtung positioniert werden zu können. Die Saugnadeln der Dreheinrichtung stehen zur Übergabe der Halbleiterbauelemente senkrecht nach oben. Nach der Übergabe verschwenkt die Dreheinrichtung um 180° und kann die Halbleiterbauelemente direkt nach unten an die Verpackung übergeben.

Ein negatives Prüfergebnis bei einem Halbleiterbauelement kann entweder dadurch zustande kommen, dass das Halbleiterbauelement nicht alle Funktionen erfüllt, es kann aber auch daran liegen, dass die Kontaktierung zwischen Prüfsockel und Halbleiterbauelement während des Tests nicht in Ordnung war. Solche Störungen können beispielsweise durch Staubkörner verursacht werden. Bisher wurden solche Halbleiterbauelemente als Abfall entsorgt. Bei teuren Halbleiterbauelementen macht es aber durchaus Sinn, solche Halbleiterbauelemente ein zweites Mal zu prüfen. Vorzugsweise ist deshalb eine Einrichtung zum Ausrichten von nochmals zu prüfenden Halbleiterbauelementen auf einem Klemmträger mit festen Anschlagelementen und beweglichen durch Federelemente vorgespannten Klemmelementen vorgesehen, mit einer Betätigungseinrichtung zum Bewegen der Klemmelemente in eine Öffnungsstellung, die das Aufsetzen der Halbleiterbauelemente durch die Ausrichteinrichtung ermöglicht und zum Bewegen der Klemmelemente in eine Klemmstellung nach dem Aufsetzen der Halbleiterbauelemente.

Es wird folglich ein leerer Klemmträger bereit gehalten, in den solche nochmals zu prüfenden Halbleiterbauelemente einsortiert werden können. Die wieder einsortierten Halbleiterbauelemente müssen die gleiche Orientierung aufweisen, wie sie sie ursprünglich in dem Klemmträger inne hatten. Bei einer Vorrichtung nach dem ersten Ausführungsbeispiel ist als Ausrichtvorrichtung eine Dreheinrichtung vorgesehen, die solche bereit mit Hilfe des des Zwischenträgers gedrehten Bauteile direkt von der Entnahmeeinrichtung übernimmt und zurückdreht. Die Dreheinrichtung kann beispielsweise seitlich versetzt unterhalb der Entnahmeeinrichtung angeordnet werden, die Entnahmevorrichtung muss in einer Ebene verfahren werden, um das nochmal zu prüfende Halbleiterbauelement an die Dreheinrichtung zu übergeben. Nach der Übergabe verschwenkt diese um 180° und legt das Halbleiterbauelement auf einen Klemmträger auf einer Ebene unterhalb des Klemmträgers aus dem es entnommen wurde, in richtiger Orientierung ab.

Bei einer Vorrichtung nach dem zweiten Ausführungsbeispiel wird die Ausrichteinrichtung durch die Entnahmeeinrichtung dargestellt. Da die Halbleiterbauelemente hier von der Entnahmeeinrichtung direkt aus dem Klemmträger entnommen werden, können sie in gleicher Ausrichtung in einen anderen Klemmträger wieder eingesetzt werden. Die Drehung der Halbleiterbauelemente ist hier also nur für die Verpackung nicht aber für die nochmalige Prüfung nötig.

Vorteilhaft ist eine Aufnahme für Kassetten vorgesehen, aus der leere Klemmträger entnehmbar und in die mit nochmal zu prüfenden Halbleiterbauelementen bestückte Klemmträger einsetzbar sind. Hierdurch wird das automatisierte Sammeln solcher nochmals zu prüfender Halbleiterbauelemente möglich. Die Kassette kann dann dem ganz normalen Prüfprozedere nochmal unterzogen werden, ohne dass besondere Maßnahmen zu treffen sind.

Die Übergabe zwischen einem Handler, in dem die Halbleiterbauelemente geprüft werden und der Entnahmevorrichtung könnte direkt erfolgen, indem jeder Klemmträger von dem Handler nach der Prüfung direkt an die Entnahmevorrichtung weitergeleitet wird. Es hat sich jedoch herausgestellt, dass bei einer solchen direkten Weitergabe bei einer Störung in einem der beiden Geräte lange Stillstandszeiten entstehen können. Da die Entnahmevorrichtung im Grunde genommen immer mit der gleichen Geschwindigkeit arbeitet, die Prüfgeschwindigkeit jedoch stark von den durchzuführenden Tests abhängig ist, könnte bei der direkten Übergabe auch keine entsprechende Anpassung erfolgen. Es wird deshalb erfindungsgemäß eine Aufnahme für Kassetten vorgesehen, aus der mit geprüften Halbleiterbauelementen bestückte Klemmträger entnehmbar sind. Da auch der Handler die geprüften Halbleiterbauelemente auf den Klemmträgern in Kassetten ablegt, wird auf diese Weise ein beliebig großer Pufferspeicher realisiert, über den die unterschiedlichen Gerätegeschwindigkeiten ausgeglichen werden können.

Um die schlechten Halbleiterbauelemente, die die geforderten Funktionen nicht erfüllen, geregelt entsorgen zu können, ist ein Behälter vorgesehen, in den diejenigen geprüften Halbleiterbauelemente abgelegt werden, die entsprechend den in dem Datenspeicher abgelegten Daten unbrauchbar sind.

Während die "schlechten" Halbleiterbauelemente entsorgt werden müssen, müssen die "guten" Halbleiterbauelemente verpackt werden. Hierzu müssen sie beispielsweise in Gurte eingelegt werden, die mit üblichen Bestückungsautomaten kompatibel sind. Es ist deshalb vorteilhaft eine Verpackungseinrichtung vorgesehen, die diejenigen geprüften Halbleiterbauelemente übernimmt und in eine Verpackung überführt, die entsprechend den in dem Datenspeicher abgelegten Daten in Ordnung sind.

Ist der Klemmträger selbst nicht mit einem Datenspeicher versehen oder es ist kein Datenspeicher an der Kassette befestigt, so müssen die Daten zu den auf dem Klemmträger befestigten Halbleiterbauelementen von einem Zentralrechner eingelesen werden. Um die eingelesenen Daten dem jeweiligen Klemmträger zuordnen zu können, ist ein Leser zum Lesen eines an dem Klemmträger angebrachten Codes vorgesehen. Der Code kann beispielsweise als Lochcode für einen Durchlichtscanner oder als Barcode für einen Auflichtscanner ausgestaltet sein.

Erfindungsgemäß wird ein Klemmträger mit geprüften Halbleiterbauelementen aus einer Kassette entnommen, exakt positioniert, über einen Code identifiziert und es werden Daten zu jedem geprüften Halbleiterbauelement gelesen. Die Klemmelemente des Klemmträgers werden in eine das Entnehmen der Halbleiterbauelemente ermöglichende Öffnungsstellung bewegt, die Halbleiterbauelemente aus dem Klemmträger auf einen Zwischenträger entleert und die Klemmelemente in eine Ruhestellung bewegt. Der leere Klemmträger wird in eine Kassette eingesetzt und die Halbleiterbauelemente werden aus dem Zwischenträger entnommen und entsprechend der gelesenen Daten in wenigstens zwei unterschiedliche Kategorien sortiert. Dieses erste Verfahren lässt sich beispielsweise auf einer Vorrichtung nach dem ersten Ausführungsbeispiel durchführen.

Bei einem zweiten Verfahren, welches beispielsweise auf der Vorrichtung nach dem zweiten Ausführungsbeispiel durchgeführt werden kann, wird ein Klemmträger mit geprüften Halbleiterbauelementen aus einer Kassette entnommen, exakt positioniert und über einen Code identifiziert. Es werden Daten zu jedem geprüften Halbleiterbauelement gelesen, die Klemmelemente in eine das Entnehmen der Halbleiterbauelemente ermöglichende Öffnungsstellung bewegt, die Halbleiterbauelemente aus dem Klemmträger entnommen, die Klemmelemente in eine Ruhestellung bewegt und der leere Klemmträger wird wieder in eine Kassette eingesetzt. Mindestens als gut kategorisierte Halbleiterbauelemente werden um eine Achse senkrecht zur Entnahmerichtung gedreht.

Bei den als gut kategorisierten Halbleiterbauelementen ist die Drehung notwendig, um sie in der richtigen Orientierung verpacken zu können. Bei Halbleiterbauelementen, die als schlecht kategorisiert wurden, spielt es keine Rolle, ob sie gedreht werden. Sie können sowohl von der Entnahmeeinrichtung als auch von der Dreheinrichtung entsorgt werden. Sind unter den entnommenen Halbleiterbauelementen solche, die nochmals zu prüfen sind, dürfen diese nicht gedreht werden, oder müssen zurückgedreht werden, da sie in nicht gedrehter Orientierung wieder in einen anderen Klemmträger eingesetzt werden müssen.

Durch das Handling der Halbleiterbauteile nach der Prüfung können unter Umständen noch Schäden auftreten, die auch die Funktion der Halbleiterbauelemente beeinträchtigen. Solche Schäden, die durch äußere Einflüsse zu Stande kommen, können meist auch von außen festgestellt werden, da sich an den Halbleiterbauelementen Kratzer, Beulen oder Absplitterungen feststellen lassen. Um auch solche Schäden auszuschließen, werden geprüfte und für in Ordnung befundene Halbleiterbauelemente nach der Entnahme aus dem Klemmträger visuell von allen Seiten mit einer Kamera erfasst.

Werden auch Halbleiterbauelemente kategorisiert, die nochmal zu prüfen sind, muss die günstigste Methode für ihre Weiterverarbeitung herausgefunden werden. Dies ist stark von der Häufigkeit abhängig. Bei größerer Häufigkeit ist es sinnvoll solche Halbleiterbauelemente wiederum in Klemmträger einzusetzen und diese Klemmträger wieder in den normalen Prüfprozess einzugliedern. Bei geringerer Häufigkeit können Tubes oder andere Kanister verwendet werden. Halbleiterbauelemente in diesen Kanistern müssen dann vor der Bestückung von Klemmträgern wieder in den Prozess eingeschleust werden oder einer Einzelprüfung unterzogen werden.

Weitere Einzelheiten und Vorteile der Erfindung ergeben sich aus den Unteransprüchen im Zusammenhang mit der Beschreibung eines Ausführungsbeispiels, das anhand der Zeichnung eingehend erläutert wird.

Es zeigt:
- Fig. 1: eine Aufsicht auf einen mit Halbleiterbauelementen bestückten Klemmträger,
- Fig. 2: einen vergrößerten Ausschnitt des Klemmträgers aus Fig. 1,
- Fig. 3: den Ausschnitt aus Fig. 2 ohne Deckplatte,
- Fig. 4: eine schematische Darstellung eines ersten Ausführungsbeispiels einer erfindungsgemäßen Vorrichtung,
- Fig. 5: ein zweites Ausführungsbeispiel mit Dreheinrichtung für die Halbleiterbauelemente und
- Fig. 6: eine Seitenansicht des zweiten Ausführungsbeispiels in Richtung der Pfeile A in Fig. 5

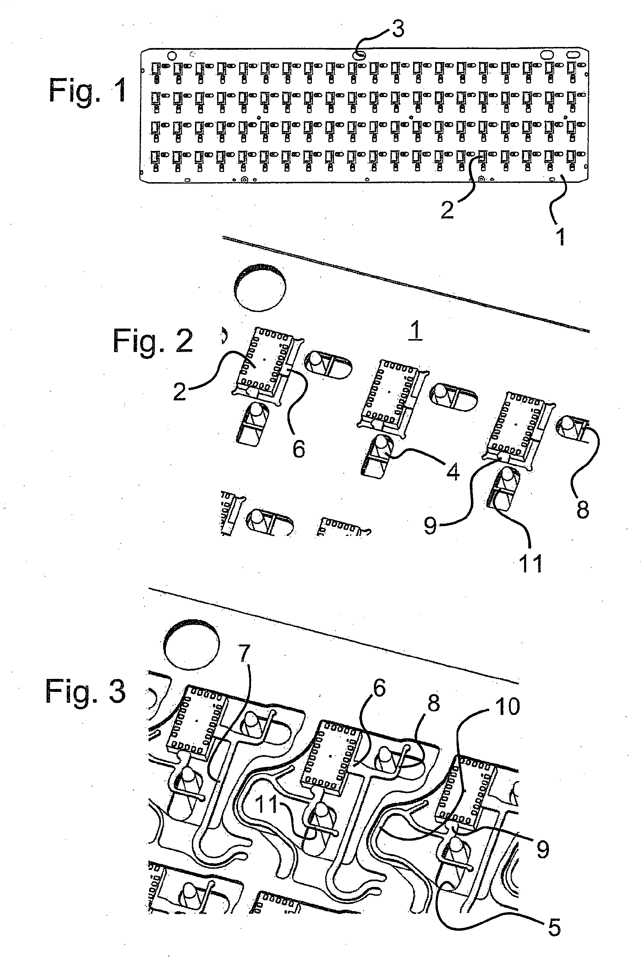

In Fig. 1 ist der Klemmträger 1 zu erkennen, der hier 80 einzelne Halbleiterbauelemente 2 enthält. Die Positionieröffnung 3 dient dazu, den Klemmträger 1 exakt positionieren zu können. Aufgrund der sehr geringen Größe der Halbleiterbauelemente 2 ist diese sehr genaue Positionierung sowohl bei der Bestückung des Klemmträgers 1 und der Entnahme der Halbleiterbauelemente 2 aus dem Klemmträger 1, aber insbesondere auch bei der Prüfung der Halbleiterbauelemente 2 notwendig. Die extrem kleinen Kontakte der Halbleiterbauelemente 2 müssen von den Prüfnadeln des Prüfsockels genau getroffen werden.

Der in Fig. 2 dargestellte Ausschnitt des Klemmträgers 1 zeigt, dass die Halbleiterbauelemente 2 von einem Querklemmelement 6 und einem Längsklemmelement 9 gegen zwei feste Anschlagkanten gedrückt werden, die durch die hier nicht extra bezeichnete, in Fig. 1 und Fig. 2 sichtbare Deckplatte des Klemmträgers 1 gebildet werden.

Die genau Funktion ist besser aus Fig. 3 zu erkennen, in der diese Deckplatte entfernt wurde und die Sicht auf die Mechanik der Klemmelemente freigegeben ist. Das Querklemmelement 6 ist mit der Querklemmfeder 7 und dem Querklemmhebel 8 verbunden. Dagegen steht das Längsklemmelement 9 mit der Längsklemmfeder 10 und dem Längsklemmhebel 11 in Verbindung. Betätigt werden die Klemmelemente 6 und 9 durch die Betätigungsstifte 4, die an den Klemmhebeln 8 und 11 angreifen. Die Klemmkraft wird von der jeweiligen Klemmfeder 7 bzw. 10 erzeugt.

Beim Bestücken des Klemmträgers 1 mit den Halbleiterbauelementen 2 wird nach dem Einsetzen der Halbleiterbauelemente 2 zuerst das Längsklemmelement 9 geschlossen, da dessen Klemmkraft geringer ist. Dabei schiebt das Längsklemmelement 9 das Halbleiterbauelement 2 gegen die ihm gegenüberliegende Anschlagkante, ohne dass von dem Querklemmelement 6 bereits eine Klemmkraft erzeugt würde. Erst dann, wenn das Längsklemmelement 9 geschlossen ist, wird auch das Querklemmelement 6 geschlossen, das über seine Querklemmfeder 7 eine Kraft erzeugt, die das Halbleiterbauelement 2 auch gegen die von dem Längsklemmelement 9 ausgehende Klemmkraft gegen die gegenüberliegende Anschlagkante drückt.

Die Betätigungsstifte 4 ragen durch die Durchgriffsöffnung 5 in den Klemmträger 1 und werden durch die hier nicht dargestellte Betätigungseinrichtung angesteuert. Zur Entnahme der Halbleiterbauelemente 2 aus dem Klemmträger 1 werden die Betätigungsstifte 4 so innerhalb der Durchgriffsöffnungen 5 verfahren, dass sie auf die Klemmhebel 8 bzw. 11 drücken und dabei die Klemmelemente 6 bzw. 9 von den Halbleiterbauelementen 2 wegziehen. Diese sind nun frei und können entnommen werden.

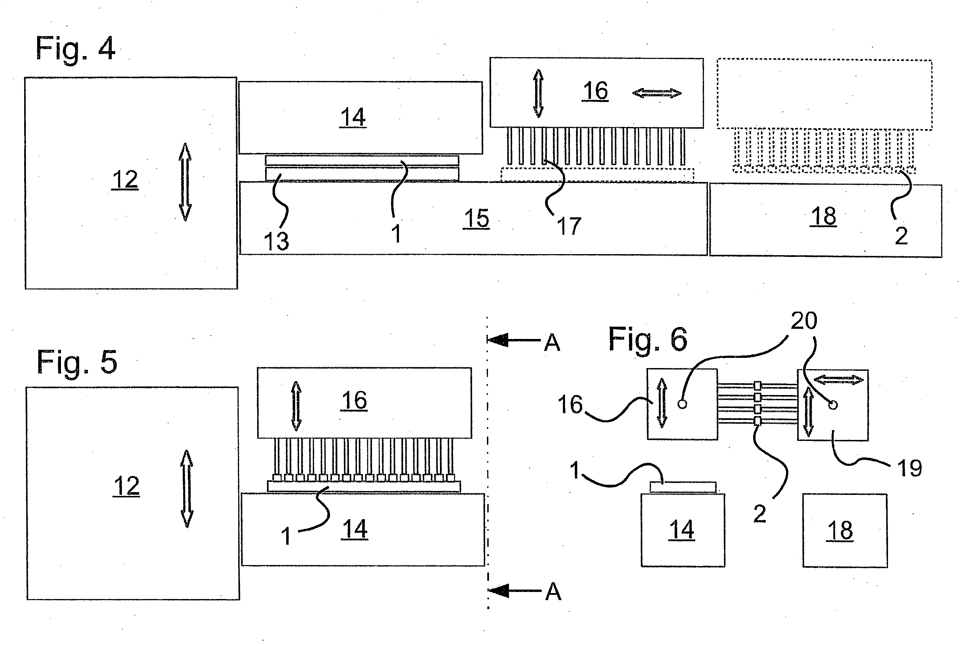

In den Fig. 4 und 5 sind Bauteile in einer ersten Stellung durchgezogen und in einer zweiten Stellung gestrichelt gezeichnet. Gleiche Bauteile sind auch mit den gleichen Bezugszeichen versehen. Die Doppelpfeile zeigen immer die Richtung an, in denen das entsprechende Bauteil bewegt werden kann.

Das Ausführungsbeispiel nach Fig. 4 weist eine Kassette 12 auf, die nach oben und unten verfahren werden kann. Alle enthaltenen Klemmträger 1 können so auf einer Ebene entnommen werden. In der untersten Stellung der Kassette 12 kann also der oberste Klemmträger 1und in der obersten Stellung der unterste Klemmträger 1 entnommen werden. Die Kassette 12 ist so ausgerichtet, dass sich die Halbleiterbauelemente auf der Unterseite der enthaltenen Klemmträger befinden.

Oberhalb des entnommenen Klemmträgers 1 befindet sich die Betätigungseinrichtung 14, die mit ihren Betätigungsstiften 4 in den Klemmträger 1 eingreift und die Klemmhebel 8 bzw. 11 betätigt. Die Betätigungseinrichtung 14 weist eine hier nicht dargestellte Führung auf, die den Klemmträger 1 aufnimmt, exakt positioniert und in dieser Stellung festhält.

Unterhalb des Klemmträgers 1 befindet sich der Zwischenträger 13, in dem die entnommenen Halbleiterbauelemente 2 abgelegt werden. Der Zwischenträger 13 ist auf dem Verschiebetisch 15 montiert, mit dessen Hilfe der Zwischenträger 13 in die gestrichelt gezeichnete Stellung unterhalb der Entnahmeeinrichtung 16 verfahren werden kann. Die Entnahmeeinrichtung 16 ist entsprechend der Doppelpfeile nach oben und unten sowie nach links und rechts verfahrbar. Sie ist mit den Saugnadeln 17 bestückt, die auf die Halbleiterbauelemente 2 in dem Zwischenträger 13 abgesenkt und nach dem Ansaugen der Halbleiterbauelemente 2 wieder angehoben werden.

Neben dem Verschiebetisch 15 ist die Verpackungseinrichtung 18 angeordnet, über die die Entnahmeeinrichtung 16 verfahrbar ist. Durch Absenken der Entnahmeeinrichtung 16 können die Halbleiterbauelemente 2 auf der Verpackungseinrichtung 18 abgelegt werden.

Die Entnahmeeinrichtung 16 kann mit einem Array an Saugnadeln 17 ausgestattet sein, so dass alle Halbleiterbauelemente 2 aus dem Zwischenträger 13 gleichzeitig entnommen werden können. Mit einer derartigen Entnahmeeinrichtung 16 können in der Verpackungseinrichtung 18 mehrere Gurte parallel mit Halbleiterbauelementen 2 bestückt werden. Ebenso ist es möglich, die Entnahmeeinrichtung 16 nur mit einer Reihe Saugnadeln 17 auszurüsten, so dass nur ein Gurt in der Verpackungseinrichtung 18 bestückt wird. Es ist aber auch die einzelne Entnahme aus dem Zwischenträger 13 mit einer kleinen Entnahmeeinrichtung 16 mit nur einer Saugnadel 17 möglich.

Befindet sich in dem Klemmträger 1 ein Halbleiterbauelement, das aussortiert werden muss, so verfährt die Entnahmeeinrichtung 16 mit den bereits aus dem Zwischenträger 13 entnommenen Halbleiterbauelementen 2 in eine bestimmte Position über einen hier nicht dargestellten Abfallbehälter und legt dieses defekte Bauteil dort ab. Idealerweise erfolgt dies nach der Ablage der guten Bauteile auf der Verpackungseinrichtung 18, so dass die guten Halbleiterbauelemente möglichst schnell und unbeschädigt die sichere Verpackung erreichen.

Sollen die Halbleiterbauelemente 2 nicht nur in zwei Kategorien, nämlich in die Kategorie "in Ordnung" und in die Kategorie "defekt" sortiert werden, sondern noch in die zusätzliche Kategorie "noch einmal zu prüfen", so wird idealerweise in Blickrichtung vor oder hinter der Verpackungseinrichtung 18 eine kleine Dreheinrichtung mit nur einer Saugnadeln vorgesehen. Die Saugnadel dieser in der Zeichnung nicht dargestellten Dreheinrichtung ist nach oben gerichtet. Auf diese Weise kann die Entnahmeeinrichtung 16 beispielsweise zuerst so verfahren werden, dass die als gut geprüften Halbleiterbauelemente 2 auf der Verpackungseinrichtung 18 abgelegt werden können, danach verfährt die Entnahmeeinrichtung 16 in der Weise, dass ein nochmal zu prüfendes Halbleiterbauelement direkt über der Saugnadel der Dreheinrichtung positioniert wird und von dieser übernommen werden kann und erst dann werden die defekten Halbleiterbauelemente in den Abfallbehälter entsorgt. Nach der Übernahme des nochmal zu prüfenden Halbleiterbauelements, schwenkt die Dreheinrichtung um 180° nach unten und legt das Halbleiterbauelement auf einem weiteren Klemmträger ab, der in einer Ebene unterhalb des ersten Klemmträgers 1 angeordnet ist. Durch diese Übergabe kann das Halbleiterbauelement 2 wieder in der Ausrichtung auf dem weiteren Klemmträger aufgesetzt werden,in der es von dem Prüfsockel einer Prüfvorrichtung kontaktiert werden kann.

Selbstverständlich kann die Dreheinrichtung auch über der Entnahmeeinrichtung 16 oder seitlich davon angeordnet sein. In diesen beiden Fällen muss jedoch auch die Entnahmeeinrichtung 16 drehbar aufgehängt sein.

Im Folgenden soll die Funktionsweise des Ausführungsbeispiels 1 nach Fig. 4 näher beschrieben werden. Die Kassette 12 wird in eine Position verfahren, in der der erste Klemmträger 1 entnommen werden kann. Dieser wird in die Führung der Betätigungseinrichtung 14 geschoben und dort exakt positioniert. Über eine auf dem Klemmträger 1 angebrachte Codierung wird dieser identifiziert und die dazugehörigen Daten werden von einem Zentralrechner eingelesen. Aus den Daten geht hervor, welche der Halbleiterbauelemente 2 in Ordnung sind, welche defekt sind und welche noch einmal geprüft werden müssen.

Die Betätigungsstifte 4 werden von der Betätigungseinrichtung 14 in die Durchgriffsöffnungen 5 eingefahren und damit die Klemmhebel 8 und 11 betätigt. Dadurch öffnen sich die Klemmelemente 6 und 9, so dass keine Haltekraft mehr auf die Halbleiterbauelemente 2 ausgeübt wird. Im Gegensatz zur Bestückung der Klemmträger kann bei der Entleerung die Betätigung der Klemmhebel gleichzeitig erfolgen.

Durch ihr Eigengewicht fallen Halbleiterbauelemente 2 in den Zwischenträger 13, der eine entsprechende Aufteilung aufweist, so dass die Halbleiterbauelemente 2 auch hier exakt positioniert sind. Die Halbleiterbauelemente 2 sind jetzt mit der Seite nach oben gerichtet, die ursprünglich auf dem Klemmträger 1 aufgelegen hatte. Sobald sich die Halbleiterbauelemente 2 in dem Zwischenträger 13 befinden, kann der leere Klemmträger 1 in die Kassette 12 zurück verbracht werden und der nächste gefüllte Klemmträger aus der Kassette 12 geladen, positioniert und die dazugehörigen Daten eingelesen werden. Es ist aber auch möglich, eine zweite Kassette zu verwenden, in die die leeren Klemmträger eingefahren werden.

Der Zwischenträger 13 wird nun unter die Entnahmeeinrichtung 16 verfahren und dort wiederum exakt positioniert. Die Entnahmeeinrichtung 16 wird nach unten bewegt, bis die Saugnadeln 17 auf den Halbleiterbauelementen 2 in dem Zwischenträger 13 aufsitzen. Das nun erzeugte Vakuum hält die Halbleiterbauelemente 2 fest, so dass sie bei dem Hochziehen der Entnahmeeinrichtung 16 aus dem Zwischenträger 13 entnommen und zusammen mit den Saugnadeln 17 nach oben verfahren werden.

Sobald die Halbleiterbauelemente 2 frei von dem Zwischenträger 13 sind, kann der Zwischenträger 13 zurückgefahren und wieder mit Halbleiterbauelementen von dem nächsten Klemmträger gefüllt werden.Inzwischen wird die Entnahmeeinrichtung 16 seitlich verfahren und über der Verpackungseinrichtung 18 positioniert. Dort werden entsprechend der eingelesenen Daten zuerst die für gut befundenen Halbleiterbauelemente 2 abgelegt, indem das Vakuum an den entsprechenden Saugnadeln 17 abgeschaltet wird. Falls bei den entnommenen Halbleiterbauelementen 2 ein nochmal zu prüfendes Bauteil ist, wird die Entnahmeeinrichtung 16 in Blickrichtung nach vorne, vor die Verpackungseinrichtung 18 verfahren und dieses Halbleiterbauelement an die hier nicht dargestellte Dreheinrichtung übergeben, die das Bauteil dann in einem weiteren, ebenfalls nicht dargestellten Klemmträger ablegt.

Ist auch ein defektes Halbleiterbauelement 2 dabei, verfährt die Entnahmeeinrichtung 16 anschließend in Blickrichtung hinter die Verpackungseinrichtung 18 und wirft dieses Bauteil über einem Abfallbehälter ab.

In Fig. 5 ist eine alternative Ausführungsvariante gezeigt. Bei diesem Ausführungsbeispiel
wird die Kassette 12 so platziert, dass sich die Halbleiterbauelemente 2 auf der Oberseite der enthaltenen Klemmträger 1 befinden. Hier ist kein Zwischenträger 13 vorgesehen, so dass die Halbleiterbauelemente 2 direkt durch die Entnahmeeinrichtung 16 von dem Klemmträger 1 entnommen werden können.

Der Vorgang der Öffnung der Klemmelemente ist der gleiche, wie bereits im Ausführungsbeispiel 1 beschrieben. Die Betätigungseinrichtung 14 befindet sich hier allerdings unterhalb des Klemmträgers 1, da auch der Klemmträger 1 andersherum orientiert ist. Die Verpackungseinrichtung 18 befindet sich hier in Blickrichtung hinter der Betätigungseinrichtung 14. Dies ist aus der Seitenansicht in Richtung der Pfeile A in Fig. 6 zu entnehmen.

Nach dem Öffnen der Klemmelemente und der Übernahme der Halbleiterbauelemente 2 durch die Saugnadeln 17 der Entnahmeeinrichtung 16 wird diese nach oben verfahren bis die Halbleiterbauelemente 2 frei sind. Danach wird die Entnahmeeinrichtung 16 um eine horizontale Drehachse 20, die senkrecht zur Entnahmerichtung ausgerichtet ist, um 90° geschwenkt (siehe Fig. 6) und in dieser Stellung fixiert. Die in gespiegelter Stellung wartende Dreheinrichtung 19 wird nun gegen die Entnahmeeinrichtung 16 verfahren, bis die Saugnadeln der Dreheinrichtung 19 die Halbleiterbauelemente 2 berühren. Dann wird das Vakuum in den Saugnadeln der Dreheinrichtung 19 aktiviert und in den Saugnadeln der Entnahmeeinrichtung 16 abgeschaltet. Die Halbleiterbauelemente 2 sind nun von den Saugnadeln der Dreheinrichtung 19 übernommen, so dass sich diese ein Stück von der Entnahmeeinrichtung 16 wegbewegen kann.

Die Dreheinrichtung 19 schwenkt nun um 90° um ihre Drehachse 20 nach unten und kann so durch ein zusätzliches Absenken die Halbleiterbauelemente 2 auf der Verpackungseinrichtung 18 ablegen. Die Ablage in drei unterschiedlichen Kategorien wurde bereits bei dem Ausführungsbeispiel 1 beschrieben und wird hier deshalb nicht erneut erläutert. Selbstverständlich kann auch bei diesem Ausführungsbeispiel der leere Klemmträger 1 wieder in die Kassette 12 zurückgeschoben, oder aber in eine andere leere Kassette transportiert werden. Auch die Entnahmeeinrichtung 16 und die Dreheinrichtung 19 können wie auch bei dem Ausführungsbeispiel 1 mit einer einzelnen Saugnadel 17, mit einer Reihe von Saugnadeln 17 oder mit einem Saugnadel-Array ausgestattet sein.

### Bezugszeichenliste:

- 1: Klemmträger
- 2: Halbleiterbauelement
- 3: Positionieröffnung
- 4: Betätigungsstift
- 5: Durchgriffsöffnung
- 6: Querklemmelement
- 7: Querklemmfeder
- 8: Querklemmhebel
- 9: Längsklemmelement
- 10: Längsklemmfeder
- 11: Längsklemmhebel
- 12: Kassette für Klemmträger
- 13: Zwischenträger
- 14: Betätigungseinrichtung
- 15: Verschiebetisch für Zwischenträger
- 16: Entnahmeeinrichtung
- 17: Saugnadel
- 18: Verpackungseinrichtung
- 19: Dreheinrichtung
- 20: Drehachse

## Patentansprüche

1. Vorrichtung zum Entnehmen von geprüften Halbleiterbauelementen (2) aus einem Klemmträger (1) mit festen Anschlagelementen und beweglichen, durch Federelemente vorgespannten Klemmelementen, **gekennzeichnet durch** folgende Merkmale:
• eine über dem Klemmträger (1) angeordnete Betätigungseinrichtung (14), die die Klemmelemente in eine das Entleeren des Klemmträgers (1) ermöglichende Öffnungsstellung und nach dem Entleeren in eine Ruhestellung bewegt,
• ein während des Entleerens unter dem Klemmträger (1) positionierter Zwischenträger (13), auf den der Klemmträger (1) entleert wird,
• ein Datenspeicher, in dem Daten zu jedem Halbleiterbauelement (2) abgelegt sind und
• eine Entnahmeeinrichtung (16), die die Halbleiterbauelemente (2) aus dem Zwischenträger (13) entnimmt und entsprechend der in dem Datenspeicher abgelegten Daten in wenigstens zwei unterschiedliche Kategorien sortiert.

2. Vorrichtung zum Entnehmen von geprüften Halbleiterbauelementen (2) aus einem Klemmträger (1) mit festen Anschlagelementen und beweglichen, durch Federelemente vorgespannten Klemmelementen, **gekennzeichnet durch** folgende Merkmale:
• eine Betätigungseinrichtung (14), die die Klemmelemente in eine das Entnehmen des Klemmträgers (1) ermöglichende Öffnungsstellung und, nach dem Entnehmen, in eine Ruhestellung bewegt,
• ein Datenspeicher, in dem Daten zu jedem Halbleiterbauelement (2) abgelegt sind,
• eine Entnahmeeinrichtung (16), die Halbleiterbauelemente (2) aus dem Klemmträger (1) entnimmt und
• eine Dreheinrichtung zum Drehen von aus dem Klemmträger (1) entnommenen Halbleiterbauelementen (2) über eine zur Entnahmerichtung senkrechte Achse.

3. Vorrichtung nach einem der Ansprüche 1 bis 2, **dadurch gekennzeichnet, dass** eine Einrichtung zum Ausrichten von nochmals zu prüfenden Halbleiterbauelementen (2) auf einem Klemmträger (1) mit festen Anschlagelementen und beweglichen, durch Federelemente vorgespannten Klemmelementen vorgesehen ist, mit einer Betätigungsvorrichtung (14) zum Bewegen der Klemmelemente in eine Öffnungsstellung, die das Aufsetzen der Halbleiterbauelemente (2) durch die Ausrichteinrichtung ermöglicht und zum Bewegen der Klemmelemente in eine Klemmstellung nach dem Aufsetzen der Halbleiterbauelemente (2).

4. Vorrichtung nach Anspruch 3, **dadurch gekennzeichnet, dass** eine Aufnahme für Kassetten vorgesehen ist, aus der leere Klemmträger (1) entnehmbar und in die mit nochmal zu prüfenden Halbleiterbauelementen (2) bestückte Klemmträger (1) einsetzbar sind.

5. Vorrichtung nach einem der Ansprüche 1 bis 4, **dadurch gekennzeichnet, dass** eine Aufnahme für Kassetten vorgesehen ist, aus der mit geprüften Halbleiterbauelementen (2) bestückte Klemmträger (1) entnehmbar sind.

6. Vorrichtung nach einem der Ansprüche 1 bis 5, **dadurch gekennzeichnet, dass** ein Behälter vorgesehen ist, in den diejenigen geprüften Halbleiterbauelemente (2) abgelegt werden, die entsprechend den in dem Datenspeicher abgelegten Daten unbrauchbar sind.

7. Vorrichtung nach einem der Ansprüche 1 bis 6, **dadurch gekennzeichnet, dass** eine Verpackungseinrichtung vorgesehen ist, die diejenigen geprüften Halbleiterbauelemente (2) übernimmt und in eine Verpackung überführt, die entsprechend den in dem Datenspeicher abgelegten Daten in Ordnung sind.

8. Vorrichtung nach einem der Ansprüche 1 bis 7, **dadurch gekennzeichnet, dass** ein Leser zum Lesen eines an dem Klemmträger (1) angebrachten Codes vorgesehen ist.

9. Verfahren zum Entnehmen von geprüften Halbleiterbauelementen (2) aus einem Klemmträger (1) mit festen Anschlagelementen und beweglichen, durch Federelemente vorgespannten Klemmelementen, **dadurch gekennzeichnet, dass** ein Klemmträger (1) mit geprüften Halbleiterbauelementen (2) aus einer Kassette entnommen, exakt positioniert und über einen Code identifiziert wird, Daten zu jedem geprüften Halbleiterbauelement (2) gelesen werden, die Klemmelemente in eine das Entnehmen der Halbleiterbauelemente (2) ermöglichende Öffnungsstellung bewegt, die Halbleiterbauelemente (2) aus dem Klemmträger (1) auf einen Zwischenträger (13) entleert und die Klemmelemente in eine Ruhestellung bewegt werden, der leere Klemmträger (1) wieder in eine Kassette eingesetzt wird und die Halbleiterbauelemente (2) aus dem Zwischenträger (13) entnommen und entsprechend der gelesenen Daten in wenigstens zwei unterschiedliche Kategorien sortiert werden.

10. Verfahren zum Entnehmen von geprüften Halbleiterbauelementen (2) aus einem Klemmträger (1) mit festen Anschlagelementen und beweglichen, durch Federelemente vorgespannten Klemmelementen, **dadurch gekennzeichnet, dass** ein Klemmträger (1) mit geprüften Halbleiterbauelementen (2) aus einer Kassette entnommen, exakt positioniert und über einen Code identifiziert wird, Daten zu jedem geprüften Halbleiterbauelement (2) gelesen werden, die Klemmelemente in eine das Entnehmen der Halbleiterbauelemente (2) ermöglichende Öffnungsstellung bewegt, die Halbleiterbauelemente (2) aus dem Klemmträger (1) entnommen und die Klemmelemente in eine Ruhestellung bewegt werden, der leere Klemmträger (1) wieder in eine Kassette eingesetzt wird und mindestens die als gut kategorisierten Halbleiterbauelemente (2) um eine Achse senkrecht zur Entnahmerichtung gedreht werden.

11. Verfahren nach einem der Ansprüche 9 bis 10, **dadurch gekennzeichnet, dass** geprüfte und für in Ordnung befundene Halbleiterbauelemente (2) nach der Entnahme aus dem Klemmträger (1) visuell von allen Seiten mit einer Kamera erfasst werden.

12. Verfahren nach einem der Ansprüche 9 bis 11, **dadurch gekennzeichnet,**
**dass** nochmal zu prüfende Halbleiterbauelemente (2) nach der Entnahme aus dem Klemmträger (1) in einen anderen Klemmträger, in Tubes oder in andere Kanister eingesetzt werden.

## Claims

1. Apparatus for removing tested semiconductor elements (2) out of a clamping carrier (1) having fixed abutting elements and movable clamping elements biased by spring elements, **characterized by** the following features:
- an actuating device (14) arranged above the clamping carrier (1), which moves the clamping elements in an open position enabling an emptying of the clamping carriers (1) and in a resting position after the emptying,
- an intermediate carrier (13) positioned under the clamping carrier (1) during the emptying, on which the clamping carrier (1) is emptied,
- a data storage in which data for each semiconductor element (2) are stored and
- a removing device (16) which removes the semiconductor elements (2) out of the intermediate carrier (13) and classifies them in at least two different categories corresponding to the data stored in the data storage.

2. Apparatus for removing tested semiconductor elements (2) out of a clamping carrier (1) having fixed abutting elements and moving clamping elements biased by spring elements, **characterized by** the following features:
- an actuating device (14) which moves the clamping elements in an open position enabling the removing of the clamping carriers (1) and in a resting position after the removing,
- a data storage in which data for each semiconductor element (2) are stored,
- a removing device (16) which removes semiconductor elements (2) out of the clamping carrier (1) and
- a turning device for turning semiconductor elements (2) removed out of the clamping carrier (1) over an axis perpendicular to the removing direction.

3. Apparatus according to one of the claims 1 to 2, **characterized in that** a device for aligning of semiconductor elements (2), to be tested again, on a clamping carrier (1) having fixed abutting elements and movable clamping elements biased by spring elements is arranged, with an actuating device (14) for moving the clamping elements in an open position which enables the putting of the semiconductor elements (2) by the aligning device and for moving the clamping elements in a clamping position after the putting of the semiconductor elements (2).

4. Apparatus according to claim 3, **characterized in that** a receptable for cartridges is provided out of which empty clamping carriers (1) are removable and in which clamping carriers (1) loaded with semiconductor elements (2), to be tested again, are insertable.

5. Apparatus according to one of the claims 1 to 4, **characterized in that** a receptable for cartridges is provided out of which clamping carriers (1) loaded with tested semiconductor elements (2) are removable.

6. Apparatus according to one of the claims 1 to 5, **characterized in that** a container is provided in which those of the tested semiconductor elements (2) are put which are corrupt according to the respective data stored in the data storage.

7. Apparatus according to one of the claims 1 to 6, **characterized in that** a packaging device is provided which takes those of the tested semiconductor elements (2) which are functional according to the respective data stored in the data storage and transfers them into a package.

8. Apparatus according to one of the claims 1 to 7, **characterized in that** a reader for reading a code arranged on the clamping carrier (1) is provided.

9. Method for removing tested semiconductor elements (2) out of a clamping carrier (1) having fixed abutting elements and movable clamping elements biased by spring elements, **characterized in that** a clamping carrier (1) with tested semiconductor elements (2) is removed from a cartridge, is positioned accurately and is identified by a code, data for each tested semiconductor element (2) are read, the clamping elements are moved into an open position enabling the removing of the semiconductor elements (2), the semiconductor elements (2) are emptied from the clamping carrier (1) to an intermediate carrier (13) and the clamping elements are moved in a resting position, the empty clamping carrier (1) is put back in a cartridge and the semiconductor elements (2) are removed from the intermediate carrier (13) and are classified according to the read data in at least two different categories.

10. Method for removing tested semiconductor elements (2) out of a clamping carrier (1) having fixed abutting elements and movable clamping elements biased by spring elements, **characterized in that** a clamping carrier (1) with tested semiconductor elements (2) is removed from the cartridge, is positioned accurately and is identified by a code, data for each tested semiconductor element (2) are read, the clamping elements are moved into an open position enabling the removing of the semiconductor elements (2), the semiconductor elements are removed out of the clamping carrier (1) and the clamping elements are moved in a resting position, the empty clamping carriers (1) are put back in a cartridge and at least the semiconductor elements (2) categorized as to be good are turned around an axis perpendicular to the removing direction.

11. Method according to one of the claims 9 to 10, **characterized in that** semiconductor elements (2) tested and classified as good are visually scanned from all sides with a camera after being removed out of the clamping carrier.

12. Method according to one of the claims 9 to 11, **characterized in that** the semiconductor elements (2) to be tested again are inserted in another clamping carrier (1), in tubes or in other canisters after the removing out of the clamping carrier.

## Revendications

1. Dispositif servant à retirer des composants semi-conducteurs (2) contrôlés d'un support de serrage (1) comprenant des éléments de butée immobiles et des éléments de serrage mobiles précontraints par des éléments formant ressorts, **caractérisé par** les caractéristiques qui suivent :
- un système d'actionnement (14) disposé au-dessus du support de serrage (1), lequel déplace les éléments de serrage dans une position d'ouverture permettant le retrait du support de serrage (1) et dans une position de repos, une fois le support de serrage retiré,
- un support intermédiaire (13) positionné sous le support de serrage (1) lors de l'opération consistant à retirer le support de serrage, sur lequel le support de serrage (1) est retiré,
- une mémoire de données, dans laquelle des données relatives à chaque composant semi-conducteur (2) sont mémorisées et
- un système de retrait (16), qui retire les composants semi-conducteurs (2) du support intermédiaire (13) et trie ces derniers, en conformité avec les données mémorisées dans la mémoire de données, selon au moins deux catégories différentes.

2. Dispositif servant à retirer des composants semi-conducteurs (2) contrôlés d'un support de serrage (1) comprenant des éléments de butée immobiles et des éléments de serrage mobiles précontraints par des éléments formant ressorts, **caractérisé par** les caractéristiques qui suivent :
- un système d'actionnement (14), qui déplace les éléments de serrage dans une position d'ouverture permettant le retrait du support de serrage (1) et dans une position de repos, une fois le support de serrage retiré,
- une mémoire de données, dans laquelle des données relatives à chaque composant semi-conducteur (2) sont mémorisées,
- un système de retrait (16), qui retire des composants semi-conducteurs (2) du support de serrage (1) et
- un système de rotation servant à faire tourner des composants semi-conducteurs (2) retirés du support de serrage (1) sur un axe perpendiculaire par rapport au sens de retrait.

3. Dispositif selon l'une quelconque des revendications 1 à 2, **caractérisé en ce qu'**on prévoit un système servant à orienter des composants semi-conducteurs (2) à contrôler une nouvelle fois sur un support de serrage (1) comprenant des éléments de butée immobiles et des éléments de serrage mobiles précontraints par des éléments formant ressorts, comprenant un système d'actionnement (14) servant à déplacer les éléments de serrage dans une position d'ouverture, laquelle permet la mise en place par le système d'orientation des composants semi-conducteurs (2), et servant à déplacer les éléments de serrage dans une position de serrage une fois la mise en place des composants semi-conducteurs (2) effectuée.

4. Dispositif selon la revendication 3, **caractérisé en ce qu'**est prévu un logement pour des cassettes, duquel des supports de serrage (1) vides peuvent être retirés et dans lesquels des supports de serrage (1) dotés de composants semi-conducteurs (2) à vérifier une nouvelle fois peuvent être insérés.

5. Dispositif selon l'une quelconque des revendications 1 à 4, **caractérisé en ce qu'**est prévu un logement pour des cassettes, duquel des supports de serrage (1) dotés de composants semi-conducteurs (2) contrôlés peuvent être retirés.

6. Dispositif selon l'une quelconque des revendications 1 à 5, **caractérisé en ce qu'**est prévu un récipient, dans lequel sont déposés précisément les composants semi-conducteurs (2) contrôlés, qui sont inutilisables conformément aux données mémorisées dans la mémoire de données.

7. Dispositif selon l'une quelconque des revendications 1 à 6, **caractérisé en ce qu'**un système d'emballage est prévu, lequel prend en charge précisément les composants semi-conducteurs (2) contrôlés et les transfère dans un emballage, lesdits composants semi-conducteurs étant classés conformément aux données enregistrées dans la mémoire de données.

8. Dispositif selon l'une quelconque des revendications 1 à 7, **caractérisé en ce qu'**est prévu un lecteur servant à lire un code placé au niveau du support du serrage (1).

9. Procédé servant à retirer des composants semi-conducteurs (2) contrôlés d'un support de serrage (1) comprenant des éléments de butées immobiles et des éléments de serrages mobiles précontraints par des éléments formant ressorts, **caractérisé en ce qu'**un support de serrage (1) comprenant des composants semi-conducteurs (2) contrôlés est retiré d'une cassette, est positionné avec précision et est identifié par l'intermédiaire d'un code, **en ce que** des données relatives à chaque composant semi-conducteur (2) contrôlé sont lues, **en ce que** les éléments de serrage sont déplacés dans une position d'ouverture permettant le retrait des composants semi-conducteurs (2), **en ce que** les composants semi-conducteurs (2) sont retirés du support de serrage (1) pour être placés sur un support intermédiaire (13), et **en ce que** les éléments de serrage sont déplacés dans une position de repos, **en ce que** le support de serrage (1) vide est inséré à nouveau dans une cassette, et **en ce que** les composants semi-conducteurs (2) sont retirés du support intermédiaire (13) et sont triés conformément aux données lues selon au moins deux catégories différentes.

10. Procédé servant à retirer des composants semi-conducteurs (2) contrôlés d'un support de serrage (1) comprenant des éléments de butée immobiles et des éléments de serrage mobiles précontraints par des éléments formant ressorts, **caractérisé en ce qu'**un support de serrage (1) comprenant des composants semi-conducteurs (2) contrôlés est retiré d'une cassette, est positionné avec précision et est identifié par l'intermédiaire d'un code, **en ce que** des données relatives à chaque composant semi-conducteur (2) contrôlé sont lues, **en ce que** les éléments de serrage sont déplacés dans une position d'ouverture permettant le retrait des composants semi-conducteurs (2), **en ce que** les composants semi-conducteurs (2) sont retirés su support de serrage (1) et **en ce que** les éléments de serrage sont déplacés dans une position de repos, **en ce que** le support de serrage (1) vide est inséré à nouveau dans une cassette, et **en ce qu'**au moins les composants semi-conducteurs (2) associés correctement à une catégorie sont pivotés selon un axe de manière perpendiculaire par rapport au sens de retrait.

11. Procédé selon l'une quelconque des revendications 9 à 10, **caractérisé en ce que** des composants semi-conducteurs (2) contrôlés et situés dans le bon ordre sont détectés, après le retrait du support de serrage (1), visuellement de tous les côtés à l'aide d'une caméra.

12. Procédé selon l'une quelconque des revendications 9 à 11, **caractérisé en ce que** des composants semi-conducteurs (2) à contrôler une nouvelle fois sont insérés, après le retrait du support de serrage (1), dans un autre support de serrage, dans des tubes ou dans d'autres bidons.
